# EUROPÄISCHE PATENTANMELDUNG

(11) **EP 4 827 314 A2**
(43) Veröffentlichungstag der Anmeldung: **21.10.2026**
(21) Anmeldenummer: 26172071.8
(22) Anmeldetag: 13.04.2026
(51) Int. Cl.: H10W 90/10, H10W 70/65, H10W 90/00

(54) **LEISTUNGSMODUL**

(30) Priorität: 15.04.2025 DE 102025114707
(71) Anmelder: Volkswagen Aktiengesellschaft, 38440 Wolfsburg (DE)
(72) Erfinder: Wilke, Robert, 38440 Wolfsburg (DE); Bayer, Christoph Friedrich, 38440 Wolfsburg (DE)

(57) **Zusammenfassung**

Die Erfindung betrifft ein Leistungsmodul (1), wobei das Leistungsmodul (1) mindestens zwei Leistungstransistoren (4) und einen Träger (2) mit einer strukturierten Metallisierung aufweist, wobei die mindestens zwei Leistungstransistoren (4) elektrisch parallel verschaltet sind, wobei die mindestens zwei Leistungstransistoren (4) mit ihren Drain-Kontakten an einer Unterseite auf einer gemeinsamen Struktur (3) der strukturierten Metallisierung angeordnet sind, wobei auf einer der Unterseite gegenüberliegenden Oberseite der Leistungstransistoren (4) ein Source-Kontakt (S) und mindestens ein Gate-Kontakt (G) angeordnet sind, wobei die Source-Kontakte (S) der mindestens zwei Leistungstransistoren (4) durch ein gemeinsames flächiges erstes Kontaktteil (7) und die Gate-Kontakte (G) der mindestens zwei Leistungstransistoren (4) durch ein gemeinsames flächiges zweite Kontaktteil (8) miteinander verbunden sind.

## Beschreibung

Die Erfindung betrifft ein Leistungsmodul mit mindestens zwei Leistungstransistoren und einem Träger mit strukturierter Metallisierung, wobei die mindestens zwei Leistungstransistoren elektrisch parallel verschaltet sind.

Leistungsmodule mit Leistungstransistoren kommen beispielsweise zum Einsatz, um Spannungen in einem Hochvoltnetz zu schalten. Dabei ist die Stromtragfähigkeit der Leistungstransistoren begrenzt. Bei höheren Strömen muss daher entweder die Chipfläche vergrößert werden oder aber mehrere Leistungstransistoren müssen parallel geschaltet werden, um den Strom aufzuteilen. Das Vergrößern der Chipfläche hat die Nachteile, dass die Ausbeute im Produktionsprozess geringer ist und dass je nach Leistungsklasse ein anderer Chip benötigt wird. Diese Probleme werden bei einer Skalierung mittels Parallelschaltung vermieden. Nachteilig ist, dass mit zunehmender Anzahl der parallelgeschalteten Leistungstransistoren die Verdrahtung immer komplexer wird.

Der Erfindung liegt daher das technische Problem zugrunde, ein Leistungsmodul mit mindestens zwei parallelgeschalteten Leistungstransistoren zu schaffen, bei denen die elektrische Verbindungstechnik vereinfacht ist.

Die Lösung des technischen Problems ergibt sich durch ein Leistungsmodul mit den Merkmalen des Anspruchs 1. Weitere vorteilhafte Ausgestaltungen der Erfindung ergeben sich aus den Unteransprüchen.

Das Leistungsmodul weist mindestens zwei Leistungstransistoren und einen Träger mit einer strukturierten Metallisierung auf, wobei die mindestens zwei Leistungstransistoren elektrisch parallel verschaltet sind. Dabei sind die mindestens zwei Leistungstransistoren mit ihren Drain-Kontakten an einer Unterseite auf einer gemeinsamen Struktur auf der strukturierten Metallisierung angeordnet. Die Leistungstransistoren können auch IGBTs sein, sodass der Drain-Kontakt dann entsprechend ein Kollektor-Kontakt ist. Nachfolgend wird der Begriff Drain und Source daher allgemein als Kontaktbezeichnung für MOSFETs, IGBTs und GaN HEMTs verwendet. Auf einer der Unterseite gegenüberliegenden Oberseite der Leistungstransistoren sind ein Source-Kontakt und mindestens ein Gate-Kontakt angeordnet. Dabei sind die Source-Kontakte der mindestens zwei Leistungstransistoren durch ein gemeinsames flächiges erstes Kontaktteil und die Gate-Kontakte der mindestens zwei Leistungstransistoren durch ein gemeinsames flächiges zweites Kontaktteil miteinander verbunden. Hierdurch wird eine sehr niederohmige und niederinduktive Verbindung geschaffen, wobei die flächigen Kontaktteile als gemeinsame Bondfläche genutzt werden können. Hierdurch wird insbesondere das Problem der Bonddrahtführung bei vielen parallelen Leistungstransistoren (z.B. 3-6) erheblich vereinfacht. Vorzugsweise sind die Leistungstransistoren als MOSFET ausgebildet. Der Träger kann eine Leiterplatte oder eine Keramik sein (z.B. IMS, DBC, AMB).

In einer Ausführungsform sind die Kontaktteile als Bleche ausgebildet. Die Form der Bleche ist dabei abhängig von der Anzahl parallel zu schaltender Leistungstransistoren als auch von deren Anordnung zueinander abhängig. Blechteile sind sehr kostengünstig und bilden eine gute Bondfläche aus. Die Verbindung der Kontaktteile bzw. Bleche mit den Leistungstransistoren kann beispielsweise eine Löt- oder Sinterverbindung sein.

In einer weiteren Ausführungsform weist mindestens eines der Kontaktteile einen Bereich unterschiedlicher Dicke auf, sodass unter anderem das thermische Ausdehnungsverhalten angepasst werden kann.

Alternativ oder ergänzend weist das Blech mindestens eines Kontaktteils die Oberfläche vergrößernde Strukturen auf, die z.B. als Stufen und/oder als Einbuchtungen oder Einkerbungen ausgebildet sind.

In einer weiteren Ausführungsform weist das Leistungsmodul mindestens zwei weitere Leistungstransistoren auf, die ebenfalls elektrisch parallel geschaltet sind, wobei die mindestens zwei weiteren Leistungstransistoren auf einer weiteren Struktur der strukturierten Metallisierung angeordnet sind, wobei das erste Kontaktteil derart ausgebildet ist, zusätzlich die weitere Struktur zu kontaktieren.

In einer alternativen Ausführungsform erfolgt die Verbindung mittels Bonddrähten oder Bondbändchen von dem ersten Kontaktteil zur weiteren Struktur.

In einer weiteren Ausführungsform sind das erste Kontaktteil und das zweite Kontaktteil in einer gemeinsamen Leiterplatte integriert, sodass der Kontaktierungsprozess vereinfacht ist, da nur ein Bauelement (die Leiterplatte) zu den Leistungstransistoren ausgerichtet werden muss.

Dabei kann auch die Leiterplatte oberflächenvergrößernde Strukturen aufweisen. Dabei sind das erste Kontaktteil und das zweite Kontaktteil jeweils sowohl auf der Oberseite als auch auf der Unterseite der Leiterplatte angeordnet und über Vias miteinander verbunden.

In einer weiteren Ausführungsform ist eine weitere Struktur auf der strukturierten Metallisierung des Trägers vorgesehen, wobei die weitere Struktur über mindestens einen Bonddraht mit dem zweiten Kontaktteil verbunden ist. Auf der weiteren Struktur kann dann beispielsweise ein Signalpin angeordnet sein, über den die Signale eines Gate-Treibers an die Gate-Kontakte geführt werden können.

Die Erfindung wird nachfolgend anhand bevorzugter Ausführungsbeispiele näher erläutert. Die Figuren zeigen:
- Fig. 1: eine schematische Draufsicht auf ein Teil eines Leistungsmoduls,
- Fig. 2: eine schematische Draufsicht auf eine Leiterplatte,
- Fig. 3: eine schematische Querschnittsdarstellung der Leiterplatte,
- Fig. 4: eine schematische Seitenansicht auf zwei Leistungstransistoren in einer ersten Ausführungsform,
- Fig. 5: eine schematische Seitenansicht auf zwei Leistungstransistoren in einer zweiten Ausführungsform und
- Fig. 6: eine schematische Seitenansicht auf zwei Leistungstransistoren in einer dritten Ausführungsform.

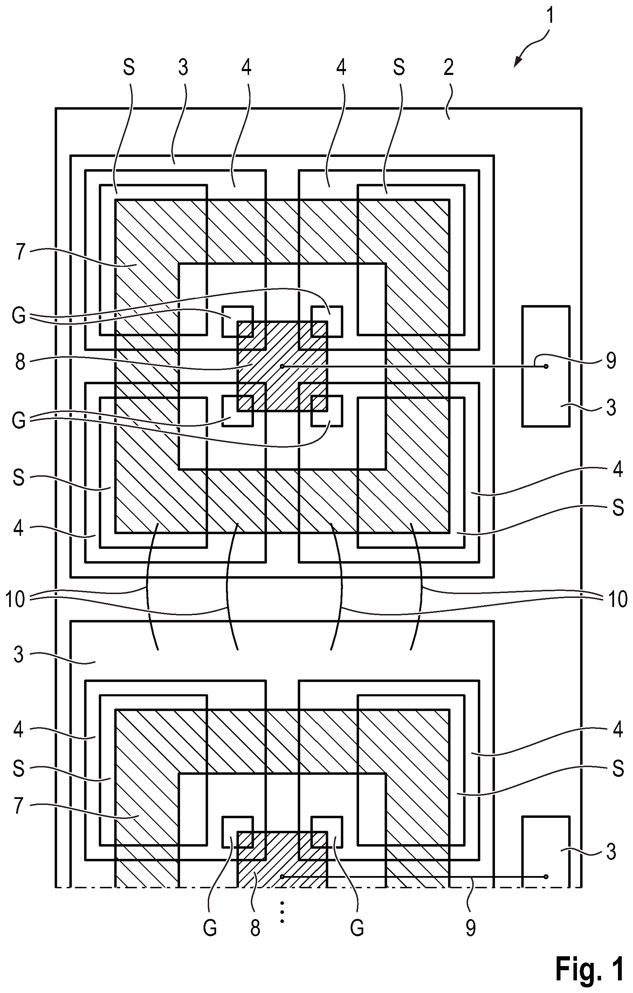

In der Fig. 1 ist eine schematische Draufsicht auf einen Teil eines Leistungsmoduls 1 dargestellt. Das Leistungsmodul 1 weist einen Träger 2 auf, der beispielsweise als Keramik ausgebildet ist. Auf der Oberseite des Trägers 2 ist eine strukturierte Metallisierung aufgebracht, die Strukturen 3 aufweist, die voneinander elektrisch isoliert sind. Auf der einen Struktur 3 sind vier Leistungstransistoren 4 angeordnet, die elektrisch parallel verschaltet sind. Dabei sind auf einer Unterseite der Leistungstransistoren 4 Drain-Kontakte angeordnet, die alle elektrisch mit dem Metall der Struktur 3 elektrisch verbunden sind (z.B. verlötet, gesintert). Die Leistungstransistoren 4 sind vorzugsweise als bare dies ausgebildet. Auf der Oberseite der Leistungstransistoren 6 ist jeweils ein größerer Source-Kontakt S und ein kleiner Gate-Kontakt G angeordnet. Dabei sind die Source-Kontakte S aller vier Leistungstransistoren 6 durch ein flächiges gemeinsames erstes Kontaktteil 7 elektrisch miteinander verbunden, wobei das erste Kontaktteil 7 schraffiert dargestellt ist. Ebenso sind alle vier Gate-Kontakte durch ein flächiges zweites Kontaktteil 8 elektrisch miteinander verbunden. Das zweite Kontaktteil 8 ist ebenfalls schraffiert dargestellt. Die vier Leistungstransistoren 6 bilden z.B. einen High-Side-Schalter einer Halbbrücke. Von dem zweiten Kontaktteil 8 ist dann beispielsweise ein Bonddraht 9 auf die rechte Struktur 3 geführt, wobei die Struktur 3 beispielsweise über einen Signalpin mit einem Gate-Treiber für die vier Leistungstransistoren 4 verbunden ist. Weiter unten ist die gleiche Verschaltung auf einer anderen Struktur 3 angeordnet, die dann den Low-Side-Schalter der Halbbrücke bildet, wobei in der Fig. 1 nur zwei der vier Leistungstransistoren 4 dargestellt sind. Die Verbindung zwischen dem ersten Kontaktteil 7 (also den Source-Kontakten S des High-Side-Schalters) mit den Drain-Kontakten des Low-Side-Schalters erfolgt z.B. über Bonddrähte 10, die mit der Struktur 3 verbunden sind. Alternativ ist das oberste erste Kontaktteil 7 derart ausgebildet, zusätzlich die untere Struktur 3 zu kontaktieren. Durch die flächigen Kontaktteile 7, 8 wird eine sehr niederohmige und niederinduktive Verbindung geschaffen, sodass die Anzahl der Bondverbindungen reduziert wird, wobei die Kontaktteile 7, 8 selbst als Bondfläche genutzt werden können.

Bei einer anderen Anzahl von parallel geschalteten Leistungstransistoren 4 müssen die Kontaktteile 7, 8 entsprechend anders geformt sein (auch abhängig von der Anordnung der Leistungstransistoren 4 zueinander). Bei einem Leistungsmodul 1 mit acht parallelen Leistungstransistoren 4 können auch jeweils vier wie zuvor beschrieben verschaltet werden, wobei dann zwei zweite Kontaktteile 8 zur Anwendung kommen (anschaulich werden die beiden Kontaktteile 7, 8 der Fig. 1 an einer Y-Achse am rechten Rand des ersten Kontaktteils 7 gespiegelt). Das erste Kontaktteil 7 und das zweite Kontaktteil 8 sind vorzugsweise als Blech (z.B. Kupfer) ausgebildet.

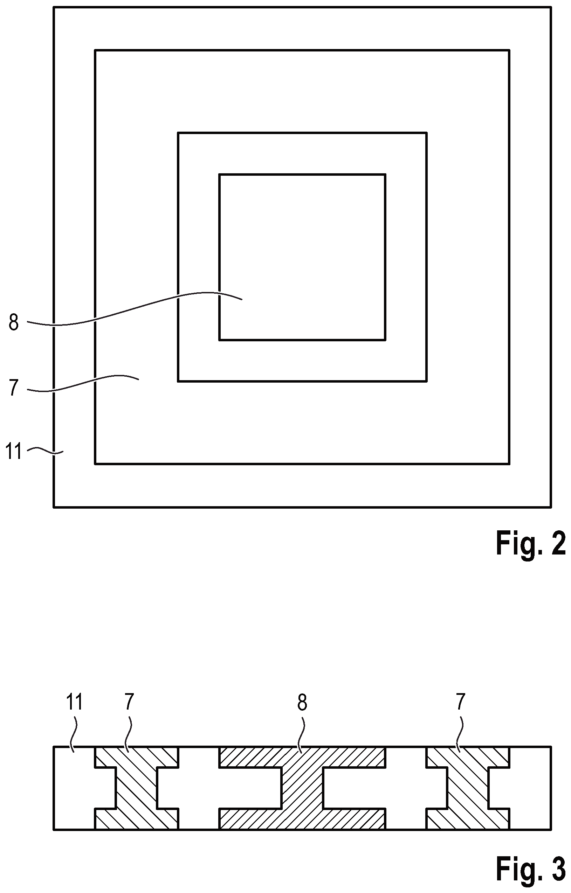

In Fig. 2 und Fig. 3 ist eine alternative Ausführungsform dargestellt, wobei das erste Kontaktteil 7 und das zweite Kontaktteil 8 zusammen in eine Leiterplatte 11 integriert sind, wobei Fig. 2 eine Draufsicht zeigt, wobei die Unteransicht analog ist. In der Fig. 3 ist eine Schnittdarstellung gezeigt, wobei die Ober- und Unterseite durch Vias verbunden sind. Dabei ist die Leiterplatte 11 nicht schraffiert dargestellt.

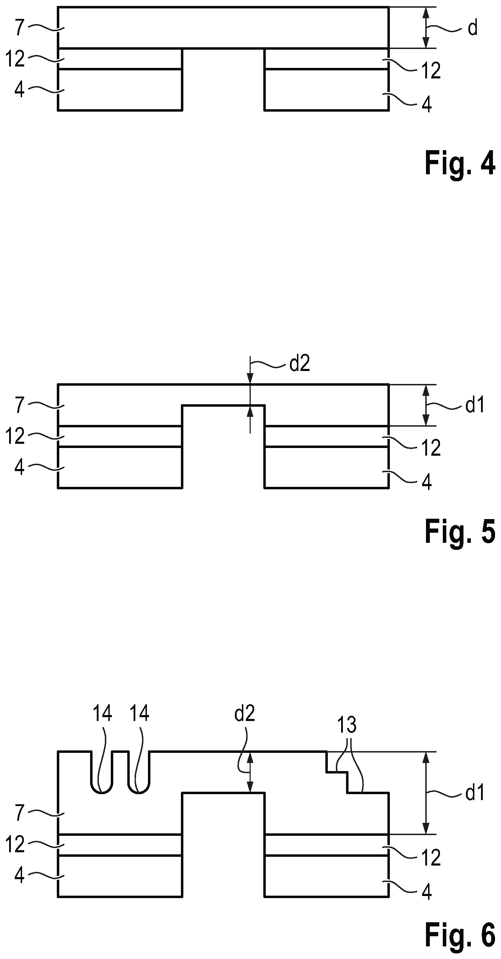

In der Fig. 4 ist eine Seitenansicht auf zwei Leistungstransistoren 4 mit einem ersten Kontaktteil 7 dargestellt, wobei zwischen diesen eine Verbindungsschicht 12 dargestellt ist, die beispielsweise als Löt- oder Sinterschicht ausgebildet ist. Dabei ist das Kontaktteil 7 als Blech ausgebildet und weist eine durchgängige konstante Dicke d auf.

In der Fig. 5 ist eine alternative Ausführungsform dargestellt, wobei das Kontaktteil 7 Abschnitte mit einer Dicke d1 und Abschnitte mit einer Dicke d2 aufweist.

In der Fig. 6 ist eine weitere Ausführungsform dargestellt, wobei das Kontaktteil 7 zusätzlich oder alternativ Stufen 13 und/oder Einbuchtungen 14 aufweist.

### Bezugszeichenliste

- 1: Leistungsmodul
- 2: Träger
- 3: Struktur
- 4: Leistungstransistor
- 6: Leistungstransistor
- 7: erstes Kontaktteil
- 8: zweites Kontaktteil
- 9: Bonddraht
- 10: Bonddraht
- 11: Leiterplatte
- 12: Verbindungsschicht
- 13: Stufe
- 14: Einbuchtung
- d, d1, d2: Dicke
- G: Gate-Kontakt
- S: Source-Kontakt

## Patentansprüche

1. Leistungsmodul (1), wobei das Leistungsmodul (1) mindestens zwei Leistungstransistoren (4) und einen Träger (2) mit einer strukturierten Metallisierung aufweist, wobei die mindestens zwei Leistungstransistoren (4) elektrisch parallel verschaltet sind, wobei die mindestens zwei Leistungstransistoren (4) mit ihren Drain-Kontakten an einer Unterseite auf einer gemeinsamen Struktur (3) der strukturierten Metallisierung angeordnet sind, wobei auf einer der Unterseite gegenüberliegenden Oberseite der Leistungstransistoren (4) ein Source-Kontakt (S) und mindestens ein Gate-Kontakt (G) angeordnet sind, **dadurch gekennzeichnet, dass**
die Source-Kontakte (S) der mindestens zwei Leistungstransistoren (4) durch ein gemeinsames flächiges erstes Kontaktteil (7) und die Gate-Kontakte (G) der mindestens zwei Leistungstransistoren (4) durch ein gemeinsames flächiges zweite Kontaktteil (8) miteinander verbunden sind.

2. Leistungsmodul nach Anspruch 1, **dadurch gekennzeichnet, dass** die Kontaktteile (7, 8) als Bleche ausgebildet sind.

3. Leistungsmodul nach Anspruch 2, **dadurch gekennzeichnet, dass** das Blech mindestens eines Kontaktteils (7, 8) Bereiche unterschiedlicher Dicke (d1, d2) aufweist.

4. Leistungsmodul nach Anspruch 2 oder 3, **dadurch gekennzeichnet, dass** das Blech mindestens eines Kontaktteils (7, 8) die Oberfläche vergrößernde Strukturierungen aufweist.

5. Leistungsmodul nach einem der vorangegangenen Ansprüche, **dadurch gekennzeichnet, dass** das Leistungsmodul (1) mindestens zwei weitere Leistungstransistoren (4) aufweist, die ebenfalls elektrisch parallel geschaltet sind, wobei die mindestens zwei weiteren Leistungstransistoren (4) auf einer weiteren Struktur (3) der strukturierten Metallisierung angeordnet sind, wobei das erste Kontaktteil (7) derart ausgebildet ist, zusätzlich die weitere Struktur (3) zu kontaktieren.

6. Leistungsmodul nach einem der Ansprüche 1 bis 4, **dadurch gekennzeichnet, dass** das Leistungsmodul (1) mindestens zwei weitere Leistungstransistoren (4) aufweist, die ebenfalls elektrisch parallel geschaltet sind, wobei die mindestens zwei weiteren Leistungstransistoren (4) auf einer weiteren Struktur (3) der strukturierten Metallisierung angeordnet sind, wobei über Bonddrähte (10) oder Bondbändchen das erste Kontaktteil (7) mit der weiteren Struktur (3) elektrisch verbunden ist.

7. Leistungsmodul nach Anspruch 1, **dadurch gekennzeichnet, dass** das erste Kontaktteil und das zweite Kontaktteil in einer gemeinsamen Leiterplatte (11) integriert sind.

8. Leistungsmodul nach einem der vorangegangenen Ansprüche, **dadurch gekennzeichnet, dass** eine weitere Struktur (3) auf der strukturierten Metallisierung vorgesehen ist, wobei die weitere Struktur (3) über mindestens einen Bonddraht (9) mit dem zweiten Kontaktteil (8) verbunden ist.
